# EUROPEAN PATENT APPLICATION

(11) **EP 1 498 962 A2**
(43) Date of publication of application: **19.01.2005**
(21) Application number: 04016602.7
(22) Date of filing: 14.07.2004
(51) Int. Cl.: H01L 51/20, H01L 27/00

(54) **Organic electroluminescence display panel**

(30) Priority: 16.07.2003 JP 2003197547
(71) Applicant: Pioneer Corporation, Meguro-ku, Tokyo (JP)
(72) Inventor: Kubota, Hirofumi, Saitama 350-2288 (JP)
(74) Representative: Klingseisen, Franz

(57) **Abstract**

An organic EL display panel is provided in which delamination does not occur. This organic EL display panel includes a substrate and a laminate on the substrate. The laminate includes a first electrode layer, an organic functional layer covering the first electrode layer, and a second electrode layer provided on the organic functional layer. The laminate is sealed by a sealing layer which covers the second electrode layer. The organic functional layer has at least one lacuna portion.

## Description

### BACKGROUND OF THE INVENTION

### 1. Field of the Invention

This invention relates to an organic electroluminescence display panel.

### 2. Description of the Related Art

Organic electroluminescence (hereafter called "organic EL") display panels, which employ an organic light-emitting material exhibiting electroluminescence properties as the light emission source, have been known in the art. A typical organic EL display panel includes an organic EL element formed on a display area of a transparent substrate. The organic EL element is made by stacking, in order, a transparent electrode, an organic functional layer containing an organic light-emitting material, and a metal electrode.

Such organic EL element is sealed by a sealing film. The sealing film is made from an inorganic material having gas barrier properties, such as silicon oxynitride (SiON). The sealing film blocks paths of intrusion of water molecules and similar into the organic EL element, and prevents formation of non-light-emitting areas called dark spots. The dark spots are indication of degradation of the organic EL element. Such sealing film is for example disclosed in Japanese Patent Kokai (Laid-open Publication) No. 8-111286.

This inorganic sealing film is usually fabricated by plasma CVD or other film deposition methods. When the sealing film is deposited, a high residual stress occurs in in-plane and other directions of the film. This residual stress acts on the multilayer structure below the sealing film, thereby deforming the multilayer structure. As a result of this deformation, delamination occurs at interfaces, such as the interface between the electrode layer and the organic functional layer, where the adhesive force is weak.

In general, adhesive forces at the interface between an organic material layer and an inorganic material layer are weak compared with the adhesive forces at interfaces between two inorganic material layers. Particularly when an organic material layer is deposited with a low-molecular weight organic material by evaporation deposition or other methods, the adhesive force at the interface is weak. Hence, if the organic functional layer is a laminate of layers made from low-molecular weight organic material, delamination occurs readily. When such delamination occurs, the organic EL element fails, and a non-emissive portion is formed.

Moreover, deformation of the sealing film results in cracks or other damage to the sealing film. When water (moisture) or other substances intrude from damaged portions, the organic EL element is degraded.

### SUMMARY OF THE INVENTION

According to one embodiment of this invention, there is provided an improved organic electroluminescence display panel. This display panel includes a substrate, a first electrode layer formed on the substrate, an organic functional layer covering the first electrode layer, a second electrode layer provided on the organic functional layer, and a sealing layer covering the second electrode layer. The organic functional layer has one or more lacuna portions.

The lacuna portion(s) can enhance adhesion between the sealing film and the substrate. Consequently even if the area over which the organic functional layer is formed is large, deformation of the sealing film does not occur readily, and so delamination of the laminate does not occur.

### BRIEF DESCRIPTION OF THE DRAWINGS

Fig. 1 is an enlarged cross-sectional view of one portion of an organic EL display panel according to one embodiment of this invention;
Fig. 2 is a cross-sectional view similar to Fig. 1 and illustrates a first modification to the organic EL display panel;
Fig. 3 is a plan view of an organic EL display panel according to a second modification;
Fig. 4 is a fragmentary enlarged plan view of an organic EL display panel according to a third modification;
Fig. 5 is a cross-sectional view taken along line V-V in Fig. 4;
Fig. 6 is a cross-sectional view taken along line VI-VI in Fig. 4;
Fig. 7 is a plan view of an organic EL display panel according to a fourth modification;
Fig. 8 is a plan view of a modification to the configuration shown in Fig. 7;
Fig. 9 illustrates another modification to the configuration shown in Fig. 7;
Fig. 10 illustrates still another modification to the configuration shown in Fig. 7; and,
Fig. 11 illustrates yet another modification to the configuration shown in Fig. 7.

### DETAILED DESCRIPTION OF THE INVENTION

An embodiment of an organic EL display panel of this invention is now described in detail, referring to the attached drawings. In the drawings, the same portions are assigned the same symbols. Although the organic EL display panel includes the wiring and driving portion necessary for display panel operation, descriptions of these are omitted below.

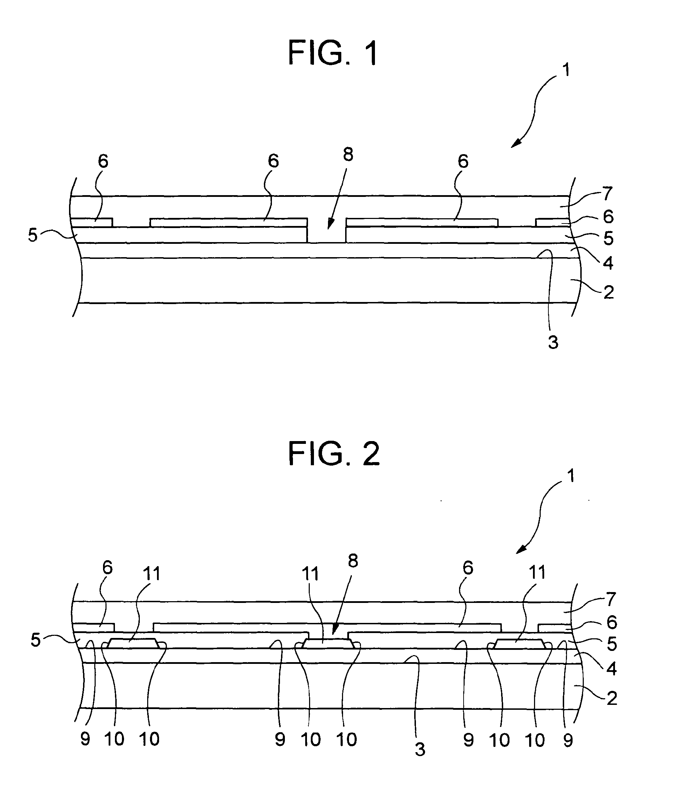

As shown in Fig. 1, an organic EL display panel 1 includes a substrate 2 of glass, resin, or other transparent material. The substrate 2 has a display area 3. Anode lines 4 which are first electrodes are formed in the display area 3. The anode lines 4 are formed from indium tin oxide (ITO) or another conductive material. An organic functional layer 5 is formed in the display area 3 so as to cover the anode lines 4. The organic functional layer 5 includes a light-emitting layer (not shown) of an organic light-emitting material having electroluminescence properties. It should be noted that the organic functional layer 5 may also include a functional layer (not shown) to enhance the efficiency of transport or injection of electrons or holes into the light-emitting layer. Cathode lines 6, which together with the anode lines 4 constitute the light-emitting area, are formed on the organic functional layer 5. The cathode lines 6 are of aluminum (Al) or another conductive material. The laminate of the above described lines and layer(s) is sealed by a sealing film 7 which covers the cathode lines 6. The sealing film 7 is of a material such as silicon nitride having gas barrier properties. The organic functional layer 5 has a lacuna portion 8. The lacuna portion 8 may be a hole which penetrates the organic functional layer 5. Alternatively, the lacuna portion 8 may extend in a gap between adjacent electrodes 4. In the lacuna portion 8, the sealing film 7 is bonded to the substrate 2 through the anode 4.

Because the organic functional layer 5 has the lacuna portion 8, bonding between the sealing film 7 and substrate 2 is enhanced. Therefore, deformation of the sealing film covering the organic functional layer does not occur readily. Consequently it is possible to prevent the occurrence of delamination even if concentration of stress occurs at interfaces between the layers.

A modified example is illustrated in Fig. 2. The organic EL display panel 1 may have an insulating film 11 on the anode line electrodes 4. The insulating film 11 has (or defines) pixel windows 10. The pixel windows 10 demarcate light-emission areas 9 on the anode line electrodes 4. The insulating layer 11 may be made from silicon oxide, silicon nitride, silicon oxynitride, or other insulating material. Alternatively, the insulating layer 11 may be made from a polyimide or other polymer. The organic functional layer 5 is formed on this insulating layer 11, and the lacuna portion 8 of the organic functional layer 5 is formed at a position other than the pixel windows 10. The cathode lines 6 are formed on the organic functional layer 5. The cathode lines 6 are bonded to the insulating layer 11 in the lacuna portion 8. The sealing film 7 is formed so as to cover the cathode lines 6.

In this display panel 1, the cathode lines 6 serve as an adhesive layer to improve the adhesion between the sealing film 7 and the insulating layer 11. Preferably, the cathode lines 6 are made from A1 because A1 adheres well to the insulating layer 11 and sealing film 7 and enhances the adhesion between the sealing film 7 and substrate 2.

It should be noted that the cathode line 6 may not be formed in the lacuna portion 8. The sealing film 7 and insulating layer 11 may be in direct contact in the lacuna portion 8.

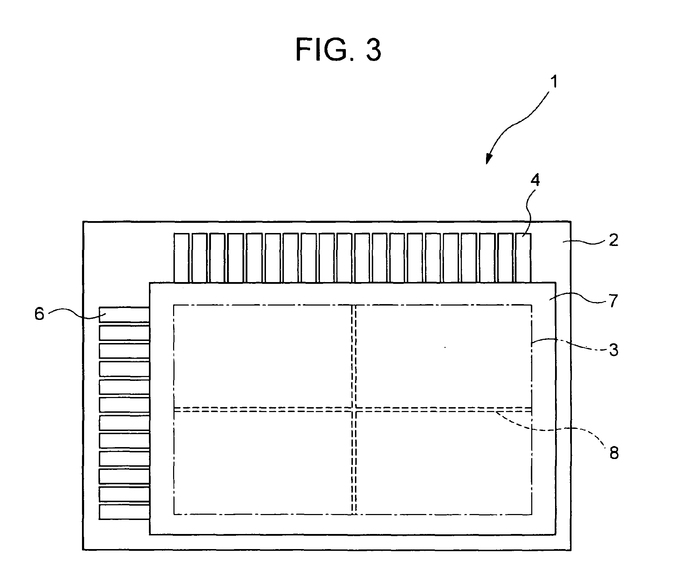

Another modification is shown in Fig. 3. The lacuna portion 8 may be a groove extending along the anode line 4 or cathode line 6. In the depth direction, the groove 8 may reach the anode line 4. The organic functional layer 5 may have two grooves 8 (i.e., the vertical and horizontal grooves 8) which intersect with each other. In the depth direction, the grooves 8 may reach the anode lines 4.

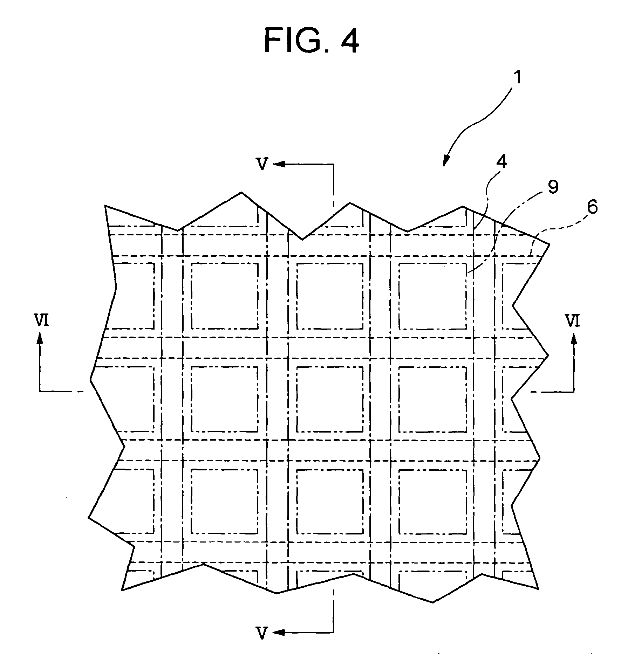

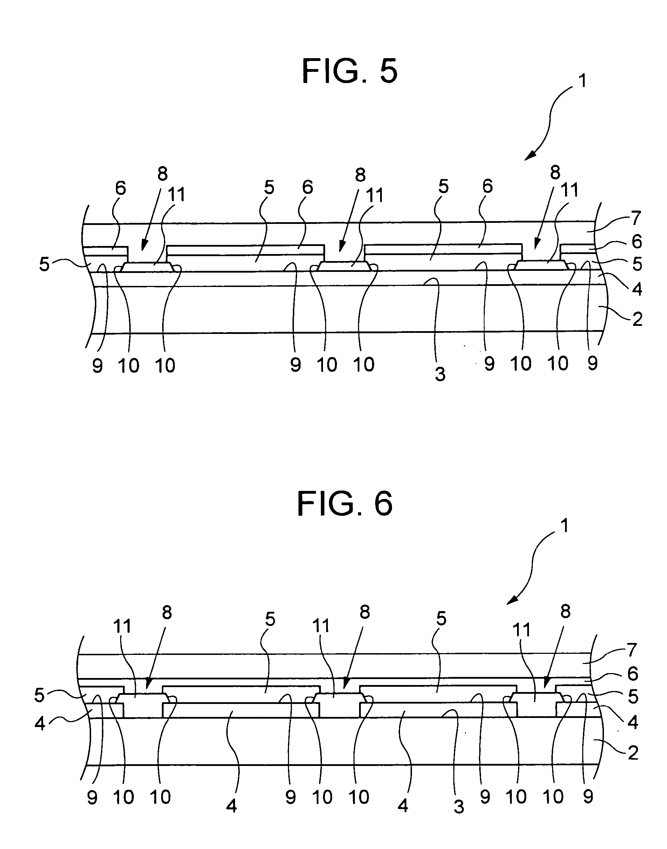

Still another modification is illustrated in Fig. 4 through Fig. 6. The organic functional layer 5 may have lacuna portions 8 which extend in gaps between all the anode lines 4 and cathode lines 6. The lacuna portions 8 may be linked with each other. The organic functional layer 5 has lacuna portions 8 in areas other than light-emitting areas 9 so that the organic functional layer 5 is constituted by a plurality of islands. In such configuration, the organic functional layer 5 can be formed only in light-emitting areas 9. As a result, the adhesive area between the sealing film 7 and substrate 2 can be increased. Moreover, even if water-induced degradation occurs in one light-emitting area, the water cannot diffuse along the organic functional layer 5. Hence spreading of the degradation to neighboring pixels can be prevented.

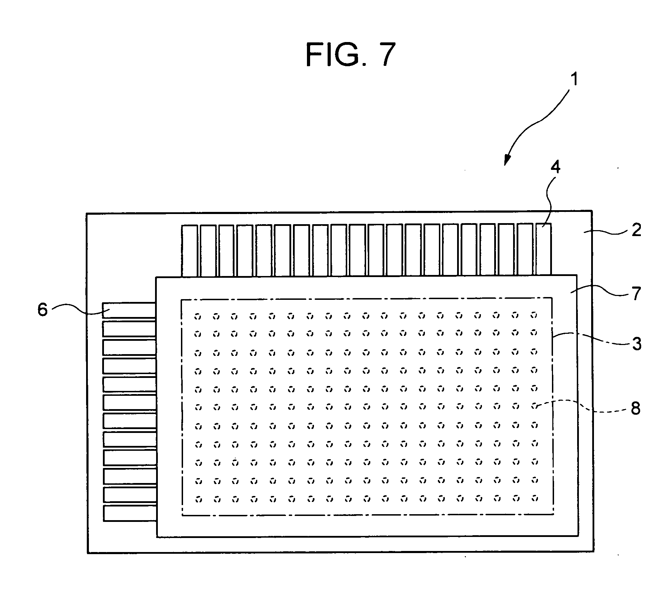

Yet another modification is shown in Fig. 7. The organic functional layer 5 may have a plurality of holes 8 as the lacuna portions. The lacuna portions 8 may be uniformly distributed (arranged) in the organic functional layer 5. In such configuration, the sealing film 7 can be bonded uniformly to the substrate 2. It should be noted that the lacuna portions 8 are not limited to holes, and may be grooves or recesses.

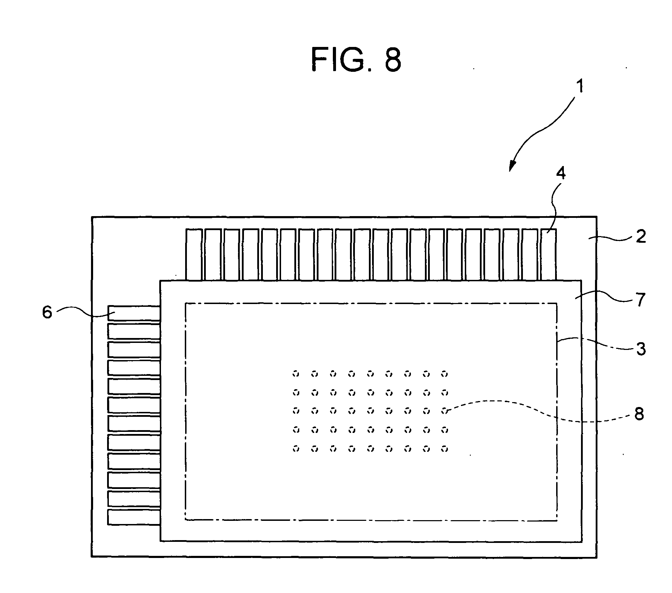

The lacuna portions 8 may be distributed unevenly in the organic functional layer 5. Four examples of such configuration are shown in Fig. 8 to Fig. 11, respectively.

In Fig. 8, the lacuna portions 8 are concentrated in a center portion of the display area 3. The display area 3 matches the shape of the organic functional layer 5. This configuration can reduce (restrict) deformation of the sealing film 7 in the center portion of the display area 3. Delamination can be prevented even when the sealing film 7 itself tends to deform in the center portion.

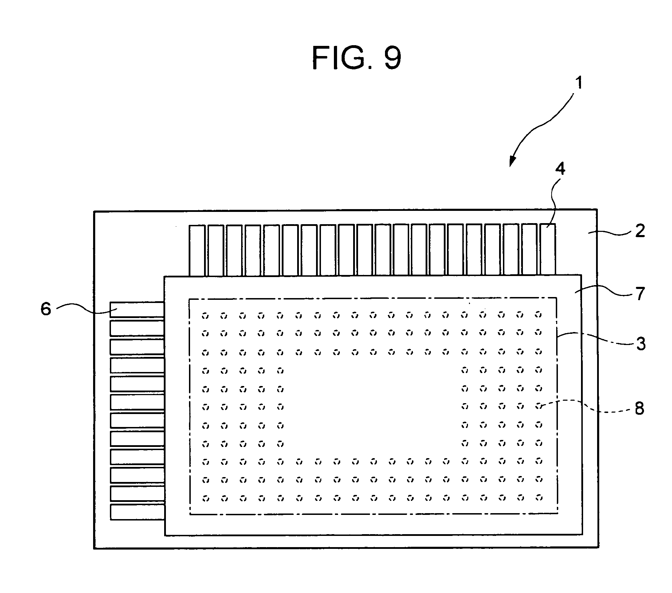

In Fig. 9, the lacuna portions 8 are concentrated along the periphery of the display area 3. These lacuna portions 8 are particularly useful to prevent deformation of the sealing film 7 near the periphery of the display area 3.

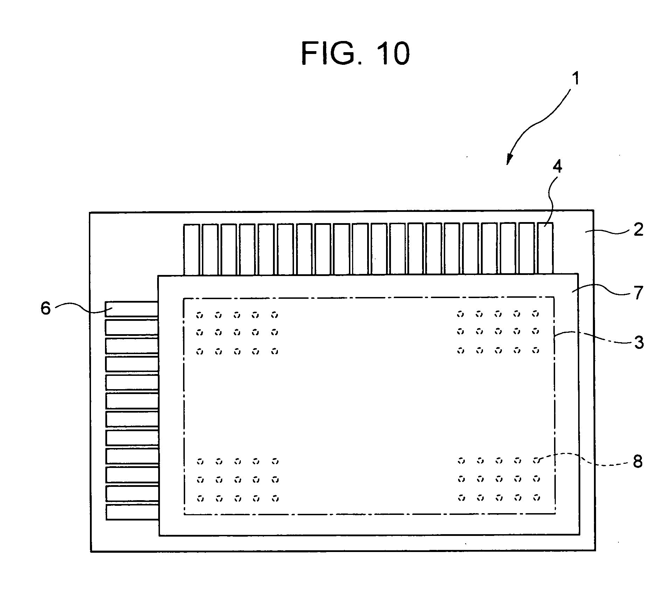

In Fig. 10, the lacuna portions 8 are concentrated near the corners of the sealing film 7. This configuration is particularly effective when the sealing film 7 has a square or rectangular shape.

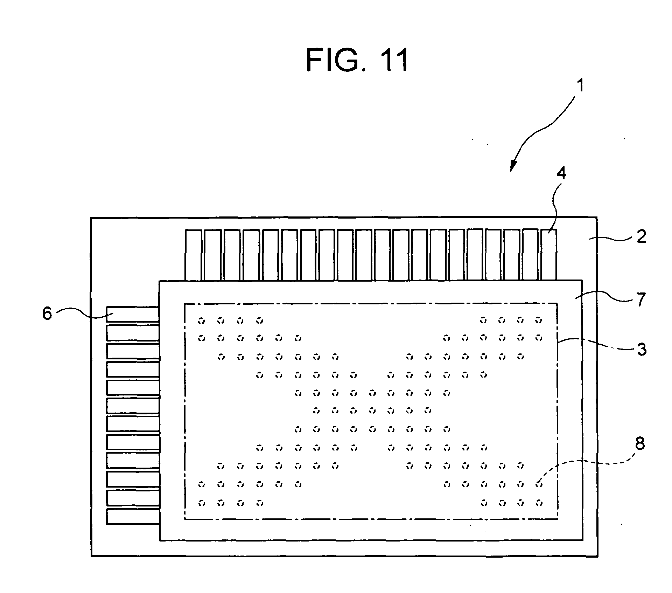

In Fig. 11, the lacuna portions 8 are concentrated along the diagonals of the sealing film 7.

By unevenly arranging the lacuna portions 8 in certain areas, it is possible to cope with various deformations. Occurrence of the deformations often depends upon a method of forming the sealing film 7 and other conditions.

The present invention is not limited to the above described and illustrated embodiment and modifications. For example, the positions of the anode electrodes 4 and cathode electrodes 6 may be interchanged. That is, the cathode electrodes 6 are formed on the substrate 2, the organic functional layer 5 is formed on the cathode electrodes 6, and the anode electrodes 4 are formed on the organic functional layer 5.

Although the anodes 4 and cathodes 6 are elongated electrode strips in the illustrated embodiment and modifications, this invention is not limited in this regard. For example, either the anodes 4 or cathodes 6 alone may be the strip-shaped electrodes and the other may be a flat electrode. For example, the organic EL display device 1 includes a plurality of strip-shaped anodes 4 and a single flat cathode 6. The flat cathode 6 is deposited over the entire surface. With such configuration, an active-type organic EL display panel can be manufactured.

## Claims

1. An organic electroluminescence display panel comprising:
a substrate;
a first electrode layer formed on said substrate;
an organic functional layer covering said first electrode layer;
a second electrode layer provided on said organic functional layer;
a sealing film covering said second electrode layer; and
at least one lacuna portion formed in said organic functional layer.

2. The organic electroluminescence display panel according to claim 1, wherein at least one of said first electrode layer and said second electrode layer comprises a plurality of mutually separated electrode pieces, and
one of said at least one lacuna portion is provided in a gap between two adjacent electrode pieces of said plurality of electrode pieces.

3. The organic electroluminescence display panel according to claim 1 or 2, further comprising an insulating layer covering said first electrode layer and having a plurality of pixel windows,
and wherein said at least one lacuna portion is formed in a position excluding said plurality of pixel windows of said insulating layer.

4. The organic electroluminescence display panel according to claim 1, 2 or 3, wherein said at least one lacuna portion includes a plurality of lacuna portions, and the plurality of lacuna portions are concentrated in a center portion of said organic functional layer.

5. The organic electroluminescence display panel according to any one of foregoing claims, wherein said at least one lacuna portion includes a plurality of lacuna portions, and the plurality of lacuna portions are concentrated along a periphery of said organic functional layer.

6. The organic electroluminescence display panel according to any one of foregoing claims, wherein said sealing film has a shape with four corners, and said at least one lacuna portion includes a plurality of lacuna portions which are concentrated near the four corners of said sealing film.

7. The organic electroluminescence display panel according to any one of foregoing claims, wherein said sealing film has a square or rectangular shape, and said at least one lacuna portion includes a plurality of lacuna portions which are concentrated along diagonals of said sealing film.
